(19) Europäisches Patentamt
European Patent Office
Office européen des brevets

(11) Publication number: **0 113 828**
**B1**

(12) **EUROPEAN PATENT SPECIFICATION**

(45) Date of publication of patent specification: **28.02.90**

(51) Int. Cl.$^5$: **H 01 L 27/02**, H 01 L 23/52, H 03 K 19/00

(21) Application number: **83111224.8**

(22) Date of filing: **10.11.83**

(54) **Master slice semiconductor chip having a new multi-function FET cell.**

(30) Priority: **12.01.83 US 457324**

(43) Date of publication of application:
**25.07.84 Bulletin 84/30**

(45) Publication of the grant of the patent:
**28.02.90 Bulletin 90/09**

(84) Designated Contracting States:
**DE FR GB IT**

(56) References cited:
**FR-A-2 276 693**
**FR-A-2 335 959**
**US-A-4 161 662**

**IBM TECHNICAL DISCLOSURE BULLETIN, vol. 24, no. 11B, April 1982, pages 5873-5874, New York, US; M. CASES et al.: "Layout scheme for fet LSI structures"**

**IBM TECHNICAL DISCLOSURE BULLETIN, vol. 24, no. 11B, April 1982, pages 5875-5876, New York, US; M. CASES et al.: "Logical flexibility enhancement for fet logic gates"**

(73) Proprietor: **International Business Machines Corporation**
**Old Orchard Road**
**Armonk, N.Y. 10504 (US)**

(72) Inventor: **Fitzgerald, Joseph Michael**
**1923 Viking Drive No. 32**
**Rochester Minnesota 55901 (US)**

(74) Representative: **Klein, Daniel Jacques Henri**
**Compagnie IBM France Département de Propriété Intellectuelle**
**F-06610 La Gaude (FR)**

(56) References cited:
**PATENTS ABSTRACTS OF JAPAN, vol. 2, no. 154 (E-78) 10008r, 25th December 1978; & JP - A - 53 123 684 (MITSUBISHI DENKI K.K.) 28-10-1978**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 113 828 B1

Courier Press, Leamington Spa, England.

**Description**

Technical field

This invention relates to large-scale integration (LSI) field-effect transistor (FET) circuits and more particularly to a masterslice design for random logic in any LSI FET technology.

Background of the invention

LSI concentration of complex circuit design provides a compact solution to circuit problems by the high packing density available in this art. This is in large part attributable to the very high percentage of the total volume consumed in the interconnecting wiring and connecting plugs required in older and more conventional designs utilizing external wiring between standard element chip packages. Since an extremely great number of circuit components must be contained on one substrate in the LSI circuit, the manufacturing process is much more complex than with a conventional circuit. As a result, the custom approach to a maximum utility of the area of the substrate by individually designing the component location and metallization connection for each required circuit is much more difficult in the LSI field than in smaller ICs.

In order to remove this deficiency present in the custom approach, a masterslice concept was developed for bipolar devices. With the masterslice concept or approach all wafers can be processed exactly alike up to the personalizable levels, and then stockpiled. Since personalization requires only a few process steps, this provides a significant reduction in the turnaround time. The masterslice concept also lends itself to auto-place and auto-wire programs which reduce the design cycle for a particular chip. Other advantages include array-like yields.

One customizing approach is described in U.S. Patent 3,983,619, in which an LSI chip is made of an array of unit cells.

All of the unit cells on the chip perform the same logical function, that is, AND, NAND, or OR. The unit cells are simple depletion-load circuits. No provision is made for powering up, that is, for having more than one power level in the unit cell. Another approach is described in U.S. Patent 4,161,662, in which an LSI chip contains a fixed number of different logic functions. There are 72 NAND logic cells and 32 D flip-flop cells on the chip. No .provision is made for powering up the logic cell.

Another approach is described in the IBM Technical Disclosure Bulletin Vol. 22, No. 5, October 1979, page 2018 to 2020 which utilizes a master image. Each part number generated using this technique has a unique set of masks; no processing of a wafer can be started until the unique set of masks for the given part number is submitted to the processing group. That is, the master-image concept only specifies where individual cells can be placed, and does not specify any FETs or other contents of the cells.

One master-slice approach that has been utilized with FET devices is described in the IBM Technical Disclosure Bulletin Vol. 22, No. 2, July 1979, page 447. A flexible FET logic cell is personalized at the contact level and at the first metal level. This allows for six logical functions. This technique uses a single depletion load circuit and does not offer any provision for powering up the logic cell. Moreover, this design requires extra processing steps, since contact vias already formed must be later specifically opened during personalization.

Summary of the invention

A cell layout provides a practical masterslice design for random logic in any LSI FET technology. Each cell is capable of the order of about 20 different functions at any of several different power levels. Multiple cells can be formed to form standard macro functions. The total number of processing steps is not any greater than required for previous custom chip designs. Conventional technology is used; no new processes or fabrication is required.

With this masterslice design the first six mask levels are common for all part numbers. All the process steps associated with the six mask levels can be completed and the wafer can be stockpiled and later personalized with the last four mask levels for a given part number. This design can use push/pull circuits for logic functions to provide a significant power-performance advantage over the simple depletion-load circuits. A single layer of conductors is sufficient to personalize any cell or macro function, so that any further conductor layer is free to run anywhere on the chip for intercell wiring.

The invention is described with more details, in the characterizing part of Claim 1. Improvements thereof are listed in subclaims.

Drawing

Figure 1 shows the overall layout areas of an integrated-circuit chip according to the invention.

Figure 2 illustrates power busses, inter-cell wiring, and cell I/O connections at the personalized upper layers of the chip.

Figure 3 shows the common lower layers of one standard cell of the chip.

Figure 4 is a schematic diagram of a standard cell before personalization.

Figure 5 is a schematic of a cell after personalization for a specific logic function and power level.

Figure 6 is a top view of the personalized first metal layer for the cell of Figure 5.

Figure 7 is a schematic of the cell of Figure 5, but personalized for a different power level.

Figure 8 is a top view of the personalized first metal layer for the cell of Figure 7.
Figure 9 is a schematic of a logic function requiring two cells.
Figure 10 is a top view of the first personalized metal layer Figure 9.

Description of a preferred embodiment

Figure 1 shows the overall layout of an entire master-slice chip 10, having dimensions about 6.2 mm square. The chip preferable uses conventional silicon-gate N-channel field-effect-transistor (FET) technology. About 100 areas such as 11 around the chip edges contain input-output cells having circuits and contacts for transmitting signals between the chip and external conductors on a substrate, not shown. These I/O cells may be conventional, or they may have a design created especially for this chip but not forming a part of the present invention.

About 2500 internal standard cells such as 12 contain circuits which can be personalized to perform various logic functions, either individually or in contiguous groups or macros of up to four cells. (Larger macros can also be defined, however. The term "cell" by itself will hereinafter refer only to the standard cells 12. These cells are arranged in lines such as 13; most of the lines are disposed in back-to-back pairs for easier power distribution. Wiring bays such as 14 run between the lines for inter-cell signal distribution at the first conductor level. Bay 15 carries conventional major power buses.

Figure 2 details a small portion of chip 10. Proceeding from the top downtoward the substrate, second-level metal (M2) conductors such as 20 run vertically over the cell lines 13 as well as over bays 14—15 to distribute signals. These conductors may be spaced as closely as allowed by the technology; presently 2-micron photolithography is used. Separated from second metal by an insulating layer, similar first-level metal (M1) conductors such as 21 run horizontally in the bays 14 between the cell lines 13. Cell I/O contacts such as 22 at this level may connect either directly to conductors 21 or through vias in the superjacent insulating layer to conductors 20. First-metal conductors 21 and second-metal conductors 20 can also couple to each other through vias, thus forming a two-dimensional matrix of signal wiring. As will be shown and described later, the first-metal layer further contains a ground bus 23 for each cell line, a supply-voltage (Vdd) bus 24 for each pair of lines, and conductors within the cells for personalizing their functions. The details of chip 10 and its layout are exemplary, and may obviously be varied to suit other conditions. Background information on the technology used in the chip may be found in Donze, et al., "Philo—A VLSI Design System", ACM/IEEE *Nineteenth Design Automation Conference Proceeding*, 1982 (ISSN 0146-7123, Library of Congress No. 76-150348).

Before discussing the layout of the individual cells, the purposes of the various layers on chip 10 will be discussed. These layers and fabrication steps are conventional, and are briefly summarized here only to facilitate an understanding of how the cell configuration of the invention may be achieved in a particular technology.

The raw silicon chip is first coated with oxide and nitride layers. A photoresist mask RX defines where the nitride is etched away; the nitride remains on areas which will become channel regions for the FETs. At this time, a boron field implant raises the threshold voltage of unwanted parasitic FETs so that they will never conduct. The oxide layer is then regrown to a greater thickness where it is not covered by the nitride, the nitride and enough oxide are removed to expose the silicon in the channel regions, and a thin oxide layer is regrown. A photoresist mask DL leaves open the channels of the load devices, and implanted arsenic ions convert only those channels to depletion mode for the DFET devices. A mask BC defines buried-contact areas, formed by etching away the thin oxide in the channel areas exposed by the mask. A polysilicon ohmic conductive layer is deposited, and another oxide layer is formed above it. These two layers are etched with a mask P1 to define the FET gate electrodes. The poly also drops through the oxide holes previously defined by the BC mask, to form the actual buried contacts. (Phosphorous from the polysilicon can then be diffused into the buried-contact areas to increase their conductivity and to define the adjacent channel edges, if desired). Arsenic is implanted through the thin oxide around the gates in the channels, to provide N+ doped source and drain electrodes for the FETs (usually called the "diffusion layer", even though it is now normally implented instead of diffused). An oxide layer is then deposited over the chip. A mask C1 defines vias etched through the last-named oxide to open contacts with the poly layer and the source/drain layer. A mask C2 for the same layer defines vias etched much more deeply around the chip edges extending all the way to the substrate for purposes not related to the invention.

The standard cells of the chp are complete at this point, and can be stockpiled pending personalization. For better protection over long time periods, they could alternatively be stockpiled before the last-named vias are opened up, or a metal layer culd be deposited over the whole chip, then stripped off before further processing is begun.

Personalization begins with a mask M1 to define ohmic conductors (such as AlCuSi or similar metal) for wiring both inside the cells 12 and between cells within the lines 13 to form macros, and also in the bays 14 for inter-cell or inter-macro wiring. The conductors can be defined either by deposition, masking, and subtractive etch; or by masking, deposition, and lift-off of unwanted metal; both of these are conventional procesess. A nitride layer is then deposited on the chip, and a mask NV defines vias etched through the nitride to first-metal conductors, and also the foregoing vias to lower layers. A thick polyimide layer over the nitride reduces the capacitance between first-metal conductors and the second-metal conductors yet to come. A mask PV defines vias through this layer in the same positions as those in the nitride below. A mask

M2 defines ohmic conductors in the same manner and composition as the first-metal layer, to form the second-metal layer conductors. These latter conductors link up to the NV/PV vias to provide inter-cell wiring as described elsewhere. It should be noted again that all intra-cell and intra-macro wiring can be achieved totally within the first-metal layer, so that second-metal is free to run anywhere on the chip, not only within prescribed bays or other restricted areas. Finally, a second polyimide protective layer is laid down, and a mask TV defines vias for connecting off-chip terminals such as solder-ball or C4 contacts; these are not relevant to the invention.

According to known techniques, the personalization may proceed even further, by depositing a third insulating layer, forming a new set of vias, then depositing a further conductive layer, etc...

An outline of the mask sequence gives a good overview of the entire process:

RX defines the FET source/drain/channel "diffusion" bodies of the FET devices.

DL defines which FETs are to be DFETs.

BC defines the buried-contact vias for connecting the FET bodies to the gate regions.

P1 defines the polysilicon FET gates.

C1 defines contact vias for connecting first-metal to polysilicon and vias from first-metal to diffusion.

C2 defines contact vias to substrate for other purposes. (The above are common to all chips; the following masks serve to personalize each chip).

M1 defines first-level wiring, both intra- and inter-cell.

NV and PV define vias for connecting second-metal to first-metal.

M2 defines second-level inter-cell wiring.

TV defines off-chip connection points.

The names of these masks are sometimes also used herein to designate the chip layers which they affect, or the vias which they define in a layer; the exact meaning will be obvious from the context.

Figure 3 is a top view of the lower, common layers of a representative standard cell 12. This configuration is the same for all such cells, except for quadrantal symmetry; that is, a cell to the left of the one shown in Figure 3 would be reversed about a vertical axis, a cell above the one shown would be reversed about a horizontal axis, and one diagonally up and to the left would be reversed about both axes.

The lowermost layer used in the cell 12 is the RX diffusion layer 31, having the shading indicated in the box in Figure 3. An shape 311 of RX layer 31 provides channels, and source and drain conductors as well, for multiple load transistors TA—TE. The large shape 312 provides channels, sources, drain and certain fixed interconnections for logic transistors TF—TO. The set of small shapes such as 313 underlie the cell I/O pads J21—J25; their purpose is merely to drain away static charges to the substrate, thus protecting the overlying pads. The boron implant layer DL 32, shown unshaded, changes the conductivity of certain transistor channels, to convert them to depletion types (DFETs); all other transistors remain enhancement types (EFETs). DL implant shapes 321 and 322 convert TA and TB, while a single shape 323 serves for three transistors, TC—TE. The next layer, is an insulating layer having masked via holes 33 defining buried contacts (BC) between the RX diffusion layer and the next layer (polysilicon) or subsequent conductive layers. These vias, V1—V30, form the contact points by which the cell is personalized and by which it is connected to other cells. They are shown as small unshaded rectangles in Figure 3. A polysilicon layer 34 forms the gate electrodes for all the cell transistors. Wherever a poly shape overlies an RX shape, a FET exists. Poly shape 341 forms transistor TA and provides a gate-to-source short through internal via V31; shape 342 does the same for TB, using via V32. Shape 343 provides gates for TC—TE. Area 344 merely connects V7 and V21, since no RX shape underlies it. Area 345 forms gates for TF and TK, and couples them together and to contact via V10. Areas 346—350 form gates for the remaining FETs, and connect them to each other, to via holes, and to cell I/O pads 22; the I/O pads use vias V21—V25. Next, an insulating layer has vias 35 for connecting the conductors to the superjacent first-metal layer for personalization. These vias are also shown as small unshaded rectangles. In addition, C1 contains a via wherever there is a buried-contact (BC) via, that is, overlying the vias V1—V30 (but not the internal vias V31—V32).

Note that shape 312 actually forms two vertical ("diffusion") columns interconnected at both ends. Poly shapes 345—350 form horizontal rows intersecting these columns and leading to the cell I/O pads. This forms a rectangular grid of EFETs for use as logic devices in the cell.

Representative dimensions, in microns, are given below for each of the cell FETs. Greater widths and lesser lengths both increase the power level of an FET.

| Transistor | Type | Width | Length |
|---|---|---|---|
| TA | DFET | 3.80 | 5.02 |
| TB | DFET | 3.80 | 6.52 |
| TC | DFET | 3.80 | 7.52 |
| TD | DFET | 3.80 | 7.52 |
| TE | DFET | 4.30 | 3.02 |
| TF—TJ | EFET | 13.78 | 2.22 |
| TK—TO | EFET | 24.80 | 2.22 |

Figure 4 shows the circuit schematic of a single cell 12. This circuit is the same for all cells 12; the layout of Figure 4 somewhat follows the physical configuration of the representative cell shown in Figure 3, for easier visualization. Transistors TA—TO and contact vias V1—V30 carry the same designations as in Figure 3. TA—TE form a group of depletion FETs (symbolized by the diagonal bars between gate and channel) personalizable in several different configurations for use as shorted-gate load devices. The gates of TA and TB are permanently shorted to their sources, while the gates of TC—TD are coupled together but left floating. The drains of TB—TE are tied together and to via V29 for permanent connection to a positive supply bus at the first-metal layer. V30 connects TA to the supply bus permanently. The junctions between TF, TG and TK, TL are held at ground potential by the top horizontal bar of shape 312 and paralleled vias V27, V28 for permanent connection to a ground bus at the first-metal layer. The sources of TJ and TO are likewise held at ground level by the lower bar of shape 312 and V26. V20 provides an intra-cell ground connection for the personalized levels yet to come. The gates of TH—TO are coupled in pairs to three of the cell I/O pads 22 at vias V23—V25. The TG, TL gate connection is interrupted by V11, V12, and only the latter is tied to I/O via V22. The FT, TK pair are paralleled and brought to intra-cell contact V10. As stated previously, I/O pad via V21 is coupled only to V7 for intra-cell use.

The logic transistors TF—TO of cell 12 constitue two parallel columns of series-connected EFETs, whose gates are disposed in horizontal rows to form pairs of related devices in a grid. All of the inter-device connections are available for personalization at the first-metal level, either by the aforementioned contact vias or by contact vias V13—V18 along the columns. Thus, even though some specific connections are permanently made in the common layers of all cells on the chip, others, including the source/drain electrodes of the logic transistors, are made available. It should be specifically noted here that the source and drain electrodes of these FETs (as is true of most FET devices) are physically interchangeable, and depend only upon the relative voltage levels within the devices.

Figure 5 is a schematic of a cell such as 12 after personalization as a four-input NOR gate at a low power level. The four input signals A0—A3 from cell I/O pads 22 are tied to the gates of logic transistors TG—TJ. The sources of these transistors are at ground potential, while their drains are paralleled to the source of shorted-gate load transistors TC—TD whose drains are tied to Vdd. Thus, a high voltage level on any of the input signals pulls node 51 to ground; node 51 is high only when no input is active. Node 51 is tied directly to an I/O pad as the cell output, labelled OUT.

Figure 6 shows the personalized wiring pattern at the shaded M1 metal layer for achieving the low-power NOR gate of Figure 5. The Vdd supply-voltage bus 61 and the ground bus 62 are the same for all cells, as stated previously. Output node 51 goes from the uppermost I/O pad 22 under bus 62 to metal 63, which connects it to the sources of load transistors TC—TD and to the drains of logic transistors TG—TJ. Metal fingers 64—66 ensure that both the sources and drains of the remaining, unused transistors are connected to ground bus 62. Link 67 couples the gates of TG and TL together.

Figure 7 is a schematic of a four-input NOR gate at a higher power level. Devices TG—TJ operate as in Figure 5, but their drains are paralleled to load devices TA—TB, at an internal node 71. The inputs are also coupled to devices TL—TO, so that output node 72 is pulled down whenever node 71 is down. At the same time, the low level on node 71 cuts off the three paralleled load devices TC—TE by pulling their gates to ground. When node 71 goes high, TC—TE conduct because of the high level on node 71, and devices TL—TO are cut off. Devices TC—TE and TL—TO thus form a push-pull output stage, which minimizes power dissipation by having no D.C. path from Vdd to ground except possibly during switching transients.

Figure 8 shows the personalized M1 layer (shown shaded) for the circuit of Figure 7. Power and ground buses 81 and 82 occupy the same positions as the corresponding buses 61 and 62 of Figure 6. Conductor 83 couples TC—TE and TL—TO to the output node, while conductor 84 couples TA—TB and TG—TJ together and to the gates (at via V3 of Figure 3) of TC—TE. Conductors 85—86 provide the source/drain ground connections to bus 82. Link 87 joins the gates of TG and TL as before.

Many other functions can be implemented in a single cell 12 or in groups of up to four contiguous cells. Some of the available random-logic and latching functions, along with the number of cells required and the number of different power levels available for each function, are listed in the following table.

| Random logic function | Number of cells | Number of power levels |
|---|---|---|
| NOR (1—4 inputs)<br>OUTPUT=$\overline{A0+A1+A2+A3}$ | 1 | 5 |
| NOR (2—4 inputs with the A0 input inverted)<br>OUTPUT=$\overline{(\overline{A0})+B0+B1+B2}$ | 2 | 3 |
| NOR (5—9 inputs)<br>OUTPUT=$\overline{A0+A1+A2+A3+A4+A5+A6+A7+A8}$ | 2 | 5 |
| OR (1—4 inputs)<br>OUTPUT=A0+A1+A2+A3 | 1 | 3 |
| OR (5—9 inputs)<br>OUTPUT=A0+A1+A2+A3+A4+A5+A6+A7+A8 | 2 | 3 |
| NAND (2 inputs)<br>OUTPUT=$\overline{A0\cdot A1}$ | 1 | 3 |
| NAND (3—4 inputs)<br>OUTPUT=$\overline{A0\cdot A1\cdot A2\cdot A3}$ | 2 | 3 |
| AND (2 inputs)<br>OUTPUT=$A0\cdot A1$ | 1 | 3 |
| AND (3—4 inputs)<br>OUTPUT=$A0\cdot A1\cdot A2\cdot A3$ | 2 | 3 |
| XOR (2 input exclusive OR)<br>OUTPUT=$A0\oplus A1$ | 1 | 3 |
| XNOR (2 input equivalence)<br>OUTPUT=$\overline{A0\oplus A1}$ | 1 | 3 |
| SELECT 1 of 2 (selects one of two input signals)<br>OUTPUT=$(\overline{G0}\cdot A0)+(G0\cdot B0)$ | 1 | 3 |
| RCG (Ripple Carry Generator)<br>OUTPUT=$(A0\cdot B0)+((A0+B0)\cdot C0)$ | 1 | 3 |
| AO (3—4) input AND-OR)<br>OUTPUT=$(A0\cdot A1)+(B0\cdot B1)$ | 1 | 3 |
| AO (4—9 input AND-OR with gate)<br>OUTPUT=$(A0\cdot A1)+(B0\cdot B1)+(C0\cdot C1)+(D0\cdot D1)+E0$ | 2 | 3 |
| AOI (3—4 input AND-OR-INVERT)<br>OUTPUT=$\overline{(A0\cdot A1)+(B0\cdot B1)}$ | 1 | 3 |
| AOI (4—9 input AND-OR-INVERT with gate)<br>OUTPUT=$\overline{(A0\cdot A1)+(B0\cdot B1)+(C0\cdot C1)+(D0\cdot D1)+E0}$ | 2 | 3 |
| OA (3—4 input OR-AND)<br>OUTPUT=$(A0+A1)\cdot(B0+B1)$ | 1 | 3 |
| OA (4—9 input OR-AND with gate)<br>OUTPUT=$(A0+A1)\cdot(B0+B1)\cdot(C0+C1)\cdot(D0+D1)\cdot(E0)$ | 2 | 3 |
| OAI (3—4 input OR-AND-INVERT)<br>OUTPUT=$\overline{(A0+A1)\cdot(B0+B1)}$ | 1 | 3 |
| OAI (4—9 input OR-AND-INVERT with gate)<br>OUTPUT=$\overline{(A0+A1)\cdot(B0+B1)\cdot(C0+C1)\cdot(D0+D1)\cdot(E0)}$ | 2 | 3 |

| Latch functions | Number of cells | Number of power levels |
|---|---|---|
| 1-PORT POLARITY-HOLD MASTER-SLAVE LATCH<br>Any 1, 2, or 3 of the master or slave outputs or their complements are available as outputs | 3 | 3 |
| 2-PORT POLARITY-HOLD MASTER-SLAVE LATCH<br>Any 1, 2, 3, or 4 of the master or slave outputs or their complements are available as outputs | 4 | 3 |
| 1-PORT SET-RESET MASTER-SLAVE LATCH<br>Any 1, 2, or 3 of the master or slave outputs or their complements are available as outputs | 3 | 3 |
| POLARITY-HOLD LATCH (one phase only)<br>Only the in-phase output is available | 1 | 3 |
| POLARITY-HOLD LATCH (both phases)<br>Either one or both phases are available as outputs | 2 | 3 |
| 1-PORT POLARITY-HOLD MASTER-SLAVE LATCH WITH AN ADDITIONAL POLARITY HOLD DATA PORT ON THE SLAVE<br>Any 1, 2, 3, or 4 of the master or slave outputs or their complements are available as outputs | 4 | 3 |

Other circuits are also possible. Moreover, larger rectangular shapes or blocks of the chip can be set aside for random-access memory (RAM) or other special circuits instead of the rows of standard cells.

Figure 9 is a schematic of a two-cell macro for implementing a specific low-power nine-input OR-AND (OA) logic function:

$$OUTPUT=(A0+A1+A2)\cdot(B0+B1+B2)+(C0\cdot C1)+D0$$

Internal node 91 is held high by load transistors TC′—TD′ (primes designate FETs in the second cell of the macro). Any of the B0—B2 inputs, in combination with any of the A0—A2 inputs, will ground node 91 by creating a conductive path through logic transistors TH, TI, TI′, TG, TJ, TJ′, using node 92. Inputs C0 and C1 together will ground node 91 through TG′, TH′, as will input DO by itself through TF′. A low voltage on node 91 cuts off TF, so that load device TC hold internal node 93 high, thus turning on TD and driving output node 94 high TF is cut off by the low level on node 92. When node 92 rises, TD cuts off and TK conducts to drive output 94 low. In this circuit, TD, TK form a push-pull output stage fed by an inverter TC, FT; the remaining devices form an input logic stage.

Figure 10 shows the actual layout of the circuit of Figure 9. Two allochiral cells 12 and 12′ in the same row 13 share supply bus 101 and ground bus 102. Conductors 103—109 in the shaded M1 layer provide personalization. Conductors 105, 107, 103, and 104 respectively correspond to nodes 91—94 in Figure 9. Note that 105 and 107 extend freely across the boundary between the two cells. The personalized leftward extension of ground bus 102 disables unused devices TL—TO and TK′—TO′, avoiding power dissipation and noise generation. Macros requiring more than two cells are constructed similarly.

**Claims**

1. A masterslice semiconductor chip (10) carrying an array of repetitive malfunction cells (12) each occupying a shape within a boundary and characterized in that each cell is comprised of:

(a) A group of parallel semiconductive columns (312);

(b) a first insulating layer overlying said columns;

(c) A group of parallel conductive rows (345—350) overlying said first insulating layer perpendicular to said columns, so as to form a grid of interconnected logic FET devices (TF—TO) having gate electrodes defined by said rows and source and drain electrodes defined by said columns;

(d) a first group of vias (V1—V21) extending upwardly through said first insulating layer within said cell for connecting said source and drain electrodes to a personalizable interconnection layer above said rows;

(e) a group of I/O pads (V21—V25) disposed near said boundary and connected to at least some of said rows for connecting said rows to a personalizable interconnection level above said rows;

(f) load means including a group of load FET devices (TA—TE) selectively connectable to said logic FET devices and to a supply voltage ($V_{dd}$).

2. A chip according to Claim 1, wherein at least some of said cells are disposed in a group of parallel lines (13) on said chip.

3. A chip according to Claim 2, wherein at least some of said lines are separated by a group of wiring bays (14).

4. A chip according to Claim 3, wherein said cell boundary is a rectangle having at least one edge adjacent one of said wiring bays.

5. A chip according to Claim 4, wherein said I/O pads are disposed along said one edge.

6. A chip according to Claim 2, wherein at least some of said lines are disposed in pairs each separated from the next by a wiring bay.

7. A chip according to Claim 6, wherein at least some of the adjacent cells (12, 12') in said pairs of lines are symmetric about an axis parallel to said lines.

8. A chip according to Claim 2, wherein at least some of the adjacent cells in said lines are symmetric about an axis perpendicular to said lines.

9. A chip according to Claim 1, wherein said load means includes a first group of load FET devices having drain electrodes connected to each other and to a via communicating with said supply voltage.

10. A chip according to Claim 9, wherein said first group of load devices have sources individually connected to vias through said first insulating layer communicating with a personalizable interconnection level.

11. A chip according to Claim 10, wherein at least some of said first group of load devices have gates connected to each other and to a via communicating with a personalizable interconnection level.

12. A chip according to Claim 9, wherein said first group of load devices have source and drain electrodes comprising a single semiconductive shape.

13. A chip according to Claim 9, wherein at least one of said load devices has a source electrode tied directly to a gate electrode and to a via communicating with a personalizable interconnection level.

14. A chip according to Claim 9, wherein said load devices are depletion-FET devices.

15. A chip according to Claim 1, wherein said semiconductive columns each include a continuous diffusion shape such that all said logic FET devices in said column are connected in series.

16. A chip according to Claim 15, wherein said group of semiconductive columns comprises a pair of semiconductive columns.

17. A chip according to Claim 16, wherein said pair of semiconductive columns comprises a single diffusion shape forming said pair of columns and at least one interconnection between said columns.

18. A chip according to Claim 17, wherein said single diffusion shape includes a pair of interconnection shapes between said columns, one of said interconnection shapes being disposed at each end of said columns.

19. A chip according to Claim 15, wherein the vias in said first group alternate with said conductive rows along at least one of said columns.

20. A chip according to Claim 15, wherein at least some of said rows extend continuously across all said columns and to respective ones of said pads.

21. A method for fabricating a personalizable masterslice chip according to Claim 1 in FET technology on a semiconductor substrate conceptually divided into a pattern of congruent individual cells separated by wiring bays, said method comprising:

(a) diffusing into said substrate a group of columns in a first direction in each said cell;

(b) diffusing into said substrate at least one load-means shape in each said cell;

(c) depositing a first insulating layer on said chip;

(d) forming a first group of vias in said insulating layer communicating with said diffusion;

(e) forming a second group of vias over said load-means shape;

(f) depositing a group of conductive rows in each said cell over said insulating layer and extending across said columns so as to form a grid of series-connected logic FET devices in each said cell;

(g) depositing at least one conductive shape over said load-means shape so as to form a group of load FET devices in each said cell;

(h) depositing a second insulating layer on said chip;

(i) forming a third group of vias in said second insulating layer overlying said first and second groups of vias;

(j) forming a fourth group of vias in said second insulating layer communicating with said rows;

(k) forming a fifth group of vias in said second insulating layer communicating with said conductive shape over said load-means shape so as to allow connections to individual ones of said group of load devices.

22. A method according to Claim 22, wherein said logic FET devices are N-channel enhancement devices.

23. A method according to Claim 22, further comprising:

(l) diffusing an implant into said load-means shape so as to make said load devices N-channel depletion devices.

24. A method according to Claim 24, wherein said conductive rows are polysilicon.

25. A method according to Claim 24, further comprising:

(m) depositing a conductive layer on said chip over said second insulating layer so as to form a group of fixed power buses communicating with said columns and said load-means shape through corresponding vias in said first, second, and third groups.

26. A method according to Claim 25, wherein said last-named conductive layer further comprises a group of personalized conductors overlying said cells and communicating with said columns and with said conductive rows through at least some of said groups of vias.

27. A method according to Claim 25, wherein said last-named conductive layer further comprises personalized conductors extending between said cells and communicating with said conductive rows through said fourth and fifth groups of vias.

28. A method according to Claim 27, further comprising:

(n) depositing a third insulating layer on said chip over said last-named conductive layer;

(o) forming a sixth group of vias in said third insulating layer overlying certain of said last-named conductors;

(p) depositing a further conductive layer on said third insulating layer so as to form a further group of personalized conductors extending between certain of said sixth group of vias.

29. A method according to Claim 28, further comprising:

(q) forming a seventh group of vias in said third insulating layer overlying certain of said fourth group of vias;

(r) forming additional conductors in said further conductive layer communicating with certain of said rows through said fourth and seventh groups of vias.

**Patentansprüche**

1. Hauptkarten-Halbleiterbaustein (10) mit einer Anordnung von mehreren Zellen (12) mit mehrfachen Funktionen, wobei jede Zelle eine Form innerhalb einer Grenze einnimmt, dadurch gekennzeichnet, dass jede Zelle enthält:

(a) Eine Gruppe paralleler halbleitender Spalten (312);

(b) eine erste Isolierschicht über den besagten Spalten;

(c) eine Gruppe paralleler leitender Reihen (345—350) über der besagten ersten Isolierschicht senkrecht zu den besagten Spalten, sodass sie ein Gitter miteinander verbundener logischer FET-Schaltungen (TF-TO) bilden, welche Torelektroden besitzen, die durch besagte Reihen definiert sind, und Source- und Drain-Elektroden, die durch besagte Spalten definiert sind;

(d) eine erste Gruppe von Wegen (V1—V21), die durch besagte Isolierschicht nach oben innerhalb besagter Zelle führen, um besagte Source- und Drainelektroden mit einer individuell gestaltbaren Verbindungsschicht über den besagten Reihen zu verbinden;

(e) eine Gruppe von Ein- und Ausgangsblöcken (V21—V25), nahe an der besagten Grenze angeordnet und an mindestens einige der besagten Reihen angeschlossen, um besagte Reihen mit einer individuell gestaltbaren Verbindungsebene über den besagten Reihen zu verbinden;

(f) Lademittel einschliesslich einer Gruppe von Last-FET-Vorrichtungen (TA-TE), die selektiv an besagte logische FET-Vorrichtungen und an eine Versorgungsspannung ($V_{dd}$) anschliessbar sind.

2. Baustein gemäss Anspruch 1, in dem mindestens einige der besagten Zellen in einer Gruppe von parallelen Zeilen (13) auf besagtem Baustein angeordnet sind.

3. Baustein gemäss Anspruch 2, in dem mindestens einige der besagten Zeilen durch eine Gruppe von Verdrahtungsfeldern (14) getrennt sind.

4. Baustein gemäss Anspruch 3, in dem besagte Zellgrenze ein Rechteck ist, an dem mindestens eine Seite an besagten Verdahtungsfeldern anliegt.

5. Baustein gemäss Anspruch 4, wo besagte Ein-/Ausgangsblöck an einem Rand entlang angeordnet sind.

6. Baustein gemäss Anspruch 2, in dem mindestens einige der besagten Reihen paarweise angeordnet sind, vom nächsten jeweils durch ein Verdrahtungsfeld getrennt.

7. Baustein gemäss Anspruch 6, in dem mindestens einige der anliegenden Zellen (12, 12') in besagten Reihenpaaren symmetrisch zu einer zu besagten Reihen parallel verlaufenden Achse angeordnet sind.

8. Baustein gemäss Anspruch 2, in dem mindestens eine der anliegenden Zellen in besagten Reihen symmetrisch zu einer zu besagten Reihen senkrecht verlaufenden Achse angeordnet sind.

9. Baustein gemäss Anspruch 1, in dem besagte Lademittel eine erste Gruppe von Lade-FET-Vorrichtungen mit Drainelektroden enthält, die aneinander angeschlossen sind, und an eine Durchgangsleitung, die mit besagter Versorgungsspannung in Verbindung steht.

10. Baustein gemäss Anspruch 9, in dem besagte erste Gruppe von Ladevorrichtungen einzeln an die Durchgangsleitung angeschlossene Sourcen haben, durch besagte erste Isolierschicht, in Verbindung mpit einer individuell ausführbaren Verbindungsebene.

11. Baustein gemäss Anspruch 10, in dem mindestens einige der besagten ersten Gruppe von

Ladevorrichtungen Tore haben, die aneinander und an eine Durchgangsleitung angeschlossen ist, welche mit einer individuell gestaltbaren Verbindungsebene in Verbindung stehen.

12. Baustein gemäss Anspruch 9, in dem besagte erste Gruppe von Ladevorrichtungen Quellen und Drainelektroden haben, die eine einzelne Halbleiterform enthalten.

13. Baustein gemäss Anspruch 9, in dem mindestens eine der besagten Ladevorrichtungen eine Sourceelektrode hat, die direkt an die Torelektrode und an eine Durchgangsleitung angeschlossen ist, die mit einer individuell gestaltbaren Verbindungsebene in Verbindung steht.

14. Baustein gemäss Anspruch 9, in dem besagte Ladevorrichtungen Mehrschicht-FET-Vorrichtungen sind.

15. Baustein gemäss Anspruch 1, in dem besagte Halbleiterspalten alle eine durchgehende Verteilungsform enthalten, sodass alle besagten logischen FET-Vorrichtungen in besagter Spalte in Reihe geschaltet sind.

16. Baustein gemäss Anspruch 15, in dem besagte Gruppe von halbleitenden Spalten ein Paar halbleitender Spalten enthält.

17. Baustein gemäss Anspruch 16, in dem besagtes Paar halbleitender Spalten eine einzelen Verteilungsform enthält, welche besagtes Spaltenpaar bildet, und mindestens eine Verbindung zwischen besagten Spalten.

18. Baustein gemäss Anspruch 17, in dem besagte einzelne Verteilungsform ein Paar Verbindungsformen zwischen besagten Spalten enthält, wobei eine der besagten Verbindungsformen an jedem Ende der besagten Spalten angeordnet ist.

19. Baustein gemäss Anspruch 15, in dem die Durchgangsleitungen in besagten ersten Gruppen mit besagten leitenden Reihen an mindestens einer der besagten Spalten entlang abwechseln.

20. Baustein gemäss Anspruch 16, in dem sich mindestens eine der besagten Reihen durchgehend über alle besagten Spalten und zu den entsprechenden der besagten Blöcke ausdehnt.

21. Verfahren für die Herstellung eines individuell ausführbaren Hauptkartenbausteins gemäss Anspruch 1, in FET-Technologie auf einem Halbleitersubstrat, das von der Konzeption her in ein Muster zusammenlaufender einzelner Zellen geteilt ist, welche durch Verdahrtungsfelder getrennt sind, wobei besagtes Verfahren enthält:

(a) Diffundieren einer Gruppe von Spalten in besagtes Substrat in jeder besagten Zelle in einer ersten Richtung;

(b) Diffundieren von mindestens einem Ladeelement in jeder besagten Zelle in besagtes Substrat;

(c) Aufbringen einer ersten Isolierschicht auf besagten Baustein;

(d) Bilden einer ersten Gruppe von Durchgangsleitungen in besagter Isolierschicht, welche mit besagter Diffusion in Verbindung stehen;

(e) Bilden einer zweiten Gruppe von Durchgangsleitungen über besagte Lademittel;

(f) Aufbringen einer Gruppe leitender Reihen in jeder besagten Zelle über besagter Isolierschicht, über besagte Spalten, sodass die ein Gitter von in Reihe geschalteten logischen FET-Vorrichtungen in jeder besagten Zelle bilden;

(g) Aufbringen von mindestens einer leitenden Schicht über der besagten Lademittelform, sodass sie eine Gruppe von Last-FET-Vorrichtungen in jeder besagten Zelle bilden;

(h) Aufbringen einer zweiten Isolierschicht auf besagtem Baustein;

(i) Bilden einer dritten Gruppe von Durchgangsleitungen in besagter zweiten Isolierschicht über der besaglten ersten und zweiten Gruppe von Durchgangsleitungen;

(j) Bilden einer vierten Gruppe von Durchgangsleitungen in besagter zweiten Isolierschicht, welche mit besagten Reihen in Verbindung steht;

(k) Bilden einer fünften Gruppe von Durchgangsleitungen in besagter zweiten Isolierschicht in Verbindung mit besagter leitender Form über der besagten Lademittelform, um die Verbindungen zu einzelnen, der besagten Gruppe von Ladungsvorrichtungen gestatten.

22. Verfahren gemäss Anspruch 21, in dem besagte logische FET-Vorrichtungen N-Kanal Anreicherungsvorrichtungen sind.

23. Verfahren gemäss Anspruch 22, ferner enthaltend:

(l) Diffundieren eines Implantats in besagte Lademittelform, um besagte Ladevorrichtungen zu N-Kanal Sperrschichtvorrichtungen zu machen.

24. Verfahren gemäss Anspruch 24, worin besagte leitende Reihen Polysilikone sind.

25. Verfahren gemäss Anspruch 24, ferner enthaltend:

(m) Auftragen einer leitenden Schicht auf besagten Baustein über der besagten zweiten Isolierschicht, sodass eine Gruppe von festen Leistungsbusleitungen entsteht, welche mit besagten Spalten und besagten Lademittelformen in Verbindung stehen, durch die entsprechenden Durchgangsleitungen in den besagten ersten, zweiten und dritten Gruppen.

26. Verfahren gemäss Anspruch 25, worin besagte zuletzt genannte leitende Schicht ferner eine Gruppe individuell gestalteter Leiter über besagten Zellen enthält, die mit besagten Spalten und mit besagten leitenden Reihen durch mindestens einige der besagten Durchgangsleitungsgruppen in Verbindung stehen.

27. Verfahren gemäss Anspruch 25, worin besagte zuletzt genannte leitende Schicht ferner individuell

gestaltete Leiter enthält, die zwischen den besagten Zellen durchführen und mit besagten leitenden Reihen durch besagte vierte und fünfte Gruppe von Durchgangsleitungen in Verbindung stehen.

28. Verfahren gemäss Anspruch 27, ferner enthaltend:

(n) Aufbringen einer dritten Isolierschicht auf besagten Baustein über die besagte zuletzte genannte leitende Schicht;

(o) Bilden einer sechsten Gruppe von Durchgangsleitungen in besagter dritten Isolierschicht, die über einigen der besagten zuletzt genannten Leitern liegt;

(p) Aufbringen einer weiteren leitenden Schicht auf besagte dritte Isolierschicht, um eine weitere Gruppe von individuell gestalteten Leitern zu bilden, die zwischen gewissen der besagten sechsten Gruppen Durchgangsleitungen herausragen.

29. Verfahren gemäss Anspruch 28, ferner enthaltend:

(q) Bilden einer siebten Gruppe von Durchgangsleitungen in der besagten dritten Isolierschicht über einigen der besagten vierten Gruppe Durchgangsleitungen.

(r) Bilden von zusätzlichen Leitern in besagter weiteren leitenden Schicht in Verbindung mit einigen der besagten Reihen durch besagte vierte und siebte Gruppe Durchgangsleitungen.

**Revendications**

1. Plaquette semiconductrice (10) à tranche maîtresse portant un ensemble de cellules (12) multi-fonctionnelles répétitives occupant chacune une zone définie par une limite déterminée, caractérisée en ce que chaque cellule se compose de ce qui suit:

(a) un groupe de colonnes semiconductrices parallèles (312);

(b) une première couche isolante recouvrant lesdites colonnes;

(c) un groupe de rangées conductrices parallèles (345—350) recouvrant ladite première couche isolante perpendiculaire auxdites colonnes, de manière à former une grille de dispositifs FET logiques interconnectés (TF-TO) dont les électrodes de porte sont définies par lesdites rangées et dont les électrodes de source et de drain sont définies par lesdites colonnes;

(d) un premier groupe de trous de connexion (V1—V21) traversant verticalement ladite première couche isolante dans ladite cellule afin de connecter lesdites électrodes de source et de drain à une couche d'interconnexion située au-dessus desdites rangées et pouvant être personnalisée;

(e) un groupe de contacts d'entrée/sortie (V21—V25) disposés près de ladite limite et connectés à quelques-unes au moins desdites rangées pour connecter lesdites rangées à un niveau d'interconnexion situé au-dessus desdites rangées et pouvant être personnalisé;

(f) des moyens de charge comprenant un gropue de dispositifs FET de charge (TA-TE) pouvant être connectés de façon sélective auxdits dispositifs FET logiques et à une source de tension ($V_{dd}$).

2. Plaquette selon la revendication 1, dans laquelle quelques-unes au moins desdites cellules sont disposées en un groupe de lignes parallèles (13) sur ladite plaquette.

3. Plaquette selon la revendication 2, dans laquelle quelques-unes au moins desdites lignes sont séparées par un groupe de passages de câblage.

4. Plaquette selon la revendication 3, dans laquelle ladite limite de cellule est un rectangle dont un côté au moins est adjacent à l'un desdits passages de câblage.

5. Plaquette selon la revendication 4, dans laquelle lesdits contacts d'entrée/sortie sont disposés le long dudit côté.

6. Plaquette selon la revendication 2, dans laquelle quelques-unes au moins desdites lignes sont disposées en paires dont chacune est séparée de la suivante par un passage de câblage.

7. Plaquette selon la revendication 6, dans laquelle quelques-unes au moins des cellules adjacentes (12, 12') dans lesdites paires de lignes sont symétriques autour d'un axe parallèle auxdites lignes.

8. Plaquette selon la revendication 2, dans laquelle quelques-unes au moins des cellules adjacentes dans lesdites lignes sont symétriques autour d'un axe perpendiculaire auxdites lignes.

9. Plaquette selon la revendication 1, dans laquelle lesdits moyens de charge incluent un premier groupe de dispositifs FET de charge dont les électrodes de drain sont connectées les unes aux autres et à un trou de connexion communiquant avec ladite source de tension.

10. Plaquette selon la revendication 9, dans laquelle les sources des dispositifs de charge dudit premier groupe sont individuellement connectées à des trous de connexion par l'intermédiaire de ladite première couche isolante communiquant avec un niveau d'interconnexion susceptible d'être personnalisé.

11. Plaquette selon la revendication 10, dans laquelle les portes de quelques-uns au moins des dispositifs de charge dudit premier groupe sont connectées les unes aux autres et à un trou de connexion communiquant avec un niveau d'interconnexion susceptible d'être personnalisé.

12. Plaqeutte selon la revendication 9, dans laquelle les électrodes de source et de drain des dispositifs de charge dudit premier groupe occupent une unique zone semiconductrice.

13. Plaquette selon la revendication 9, dans laquelle l'électrode de source de l'un au moins desdits dispositifs de charge est directement reliée à une électrode de porte et à un trou de connexion communiquant avec un niveau d'interconnexion susceptible d'être personnalisé.

14. Plaquette selon la revendication 9, dans laquelle lesdits dispositifs de charge sont des dispositifs FET du type à appauvrissement.

15. Plaquette selon la revendication 1, dans laquelle chacune desdites colonnes semiconductrices inclut une zone de diffusion continue telle que tous les dispositifs FET logiques dans ladite colonne soient connectés en série.

16. Plaquette selon la revendication 15, dans laquelle ledit groupe de colonnes semiconductrices forme une paire de colonnes semiconductrices.

17. Plaquette selon la revendication 16, dans laquelle chaque paire de colonnes semiconductrices comporte une unique zone de diffusion formant ladite paire de colonnes et au moins une interconnexion entre lesdites colonnes.

18. Plaquette selon la revendication 17, dans laquelle ladite unique zone de diffusion inclut une paire de zones d'interconnexion entre lesdites colonnes, l'une desdites zones d'interconnexion étant disposée à chaque extrémité desdites colonnes.

19. Plaquette selon la revendication 15, dans laquelle les trous de connexion dudit pemier groupe alternent avec lesdites rangées conductrices le long de l'une au moins desdites colonnes.

20. Plaquette selon la revendication 15, dans laquelle quelques-unes au moins desdites rangées s'étendent de façon continue en travers de toutes lesdites colonnes et jusqu'à ceux desdits contacts qui leur correspondent.

21. Procédé de fabrication en technologie FET d'une plaquette à tranche maîtresse susceptible d'être personnalisée, sur un substrat semiconducteur dividé en une configuration de cellules individuelles congruentes séparées par des passages de câblage, ledit procédé comprenant des étapes consistant à:

(a) diffuser dans ledit substrat un groupe de colonnes dans une première direction dans chacune desdites cellules;

(b) diffuser dans ledit substrat au moins une zone comportant des moyens de charge dans chacune desdites cellules;

(c) déposer une première couche isolante sur ladite plaquette;

(d) former un premier groupe de trous de connexion dans ladite couche isolante communiquant avec ladite diffusion;

(e) former un second groupe de trous de connexion sur ladite zone comportant des moyens de charge;

(f) déposer dans chacune desdites cellules un groupe de rangées conductrices recouvrant ladite couche isolante et s'étendant en travers desdites colonnes de manière à former une grille de dispositifs FET logiques montés en série dans chacune desdites cellules;

(g) déposer au moins une zone conductrice sur ladite zone comportant des moyens de charge de manière à former un groupe de dispositifs FET de charge dans chacune desdites cellules;

(h) déposer une seconde couche isolante sur ladite plaquette;

(i) former un troisième groupe de trous de connexion dans ladite seconde couche isolante recouvrant lesdites premier et second groupes de trous de connexion;

(j) former un quatrième groupe de trous de connexion dans ladite seconde couche isolante communiquant avec lesdites rangées;

(k) former un cinquième groupe de trous de connexion dans ladite seconde couche isolante communiquant avec ladite zone conductrice au-dessus de ladite zone comportant des moyens de charge de façon à permettre d'établir des connexions avec des dispositifs de charge distincts faisant partie dudit groupe de dispositifs de charge.

22. Procédé selon la revendication 21, dans lequel lesdits dispositifs FET logiques sont des dispositifs du type à enrichissement à canal N.

23. Procédé selon la revendication 22, comprenant en outre une étape consistant à:

(l) diffuser un implant dans ladite zone comportant des moyens de charge pour réaliser lesdits dispositifs du type à enrichissement à canal N.

24. Procédé selon la revendication 24, dans lequel lesdites rangées conductrices sont en polysilicium.

25. Procédé selon la revendication 24, comprenant en outre une étape consistant à:

(m) dépoiser sur ladite plaquette une couche conductrice recouvrant ladite seconde couche isolante afin de former un groupe de conducteurs de puissance fixes communiquant avec lesdites colonnes et ladite zone comportant des moyens de charge par l'intermédiaire de trous de connexion correspondants dans lesdits premier, second et troisième groupes.

26. Procédé selon la revendication 25, dans lequel la couche conductrice mentionnée dans cette dernière comprend en outre un groupe de conducteurs personnalisés disposés sur lesdites celules et communiquant avec lesdites colonnes et avec lesdites rangées conductrices par l'intermédiaire de quelques-uns au moins desdits groupes de trous de connexion.

27. Procédé selon la revendication 25, dans lequel la couche conductrice mentionnée dans cette dernière comprend en outre des conducteurs personnalisés qui s'étendent entre lesdites cellules et qui communiquent avec lesdites rangées conductrices par l'intermédiaire desdits quatrième et cinquième groupes de trous de connexion.

28. Procédé selon la revendication 27, comprenant en outre des étapes consistant à:

(n) déposer une troisième couche isolante sur ladite plaquette au-dessus de la couche conductrice mentionnée en dernier lieu;

(o) former un sixième gropue de trous de connexion dans ladite troisième couche isolante recouvrant certains desdits conducteurs mentionnés en dernier lieu;

(p) déposer une couche conductrice supplémentaire sur ladite troisième couche isolante pour former un groupe supplémentaire de conducteurs personnalisés s'étendant entre certains des trous de connexion dudit sixième groupe.

29. Procédé selon la revendication 28, comprenant en outre des étapes consistant à;

(q) former un septième groupe de trous de connexion dans ladite troisième couche isolante recouvrant certains des trous de connexion dudit quatrième groupe;

(r) former des conducteurs supplémentaires dans ladite couche conductrice supplémentaire communiquant avec certaines desdites rangées par l'intermédiaire desdits quatrième et septième groupes de trous de connexion.

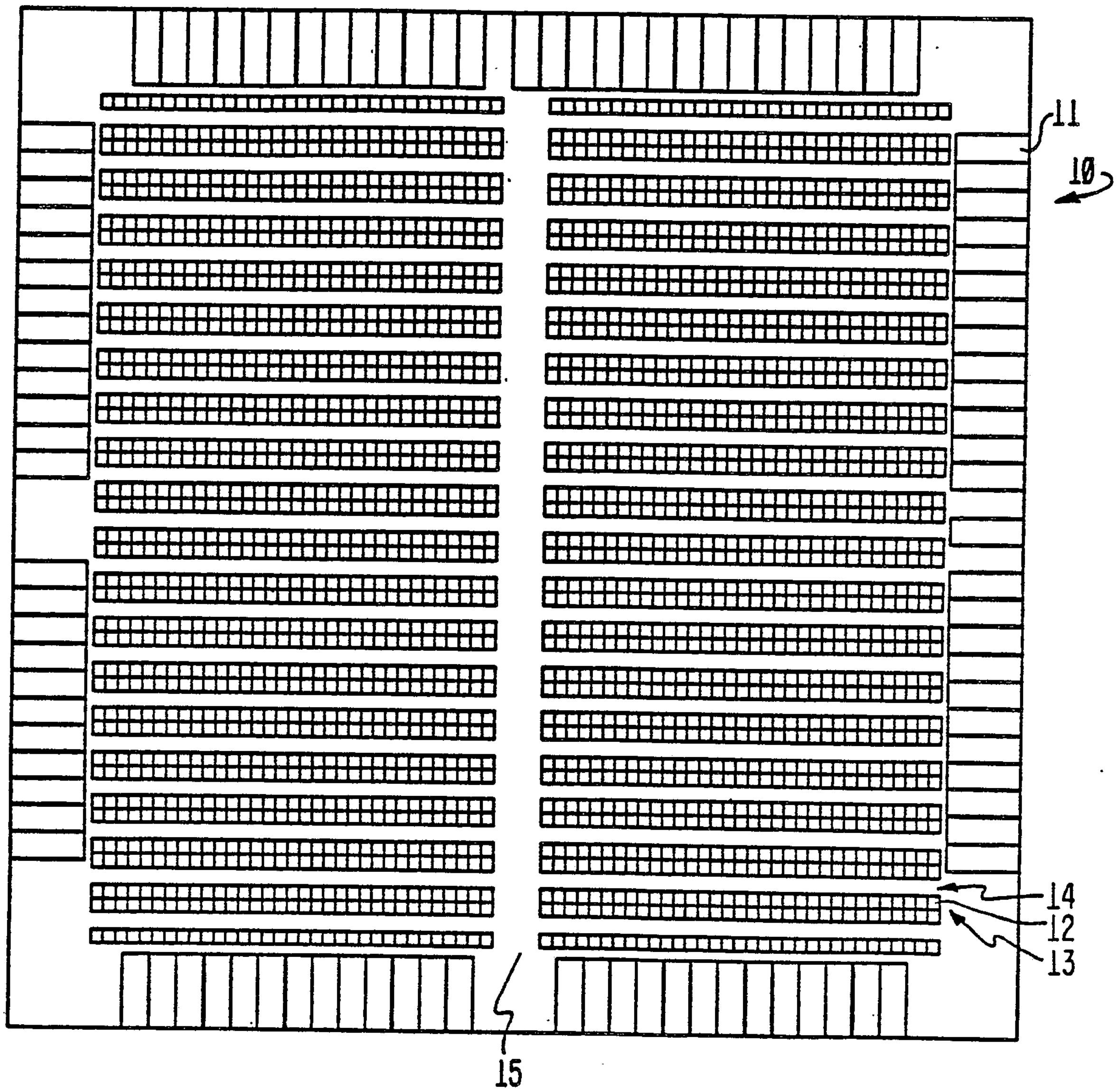


FIG. 1

FIG. 2

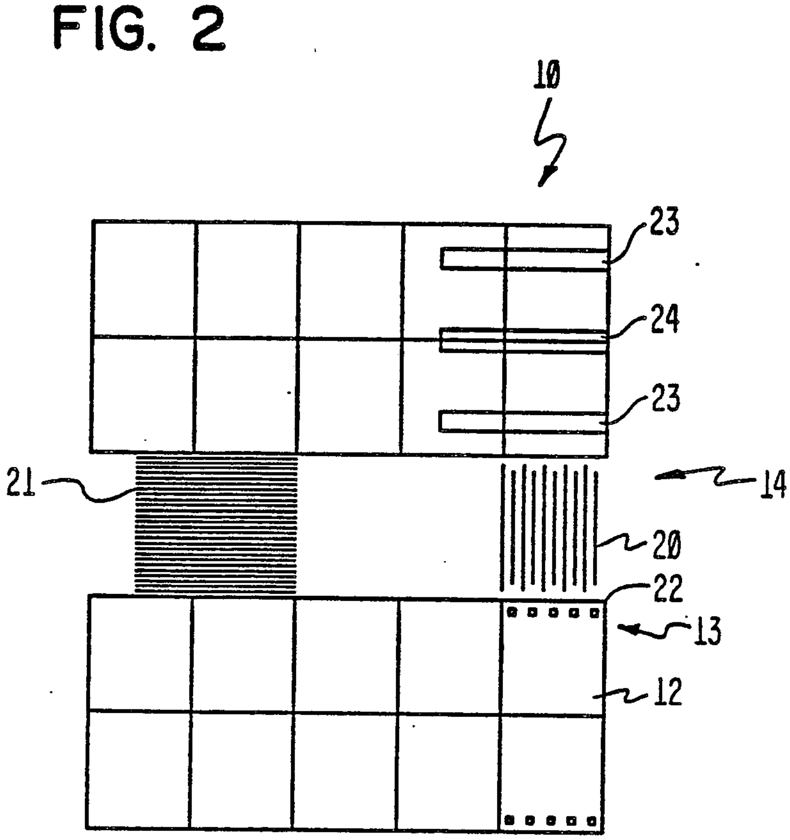

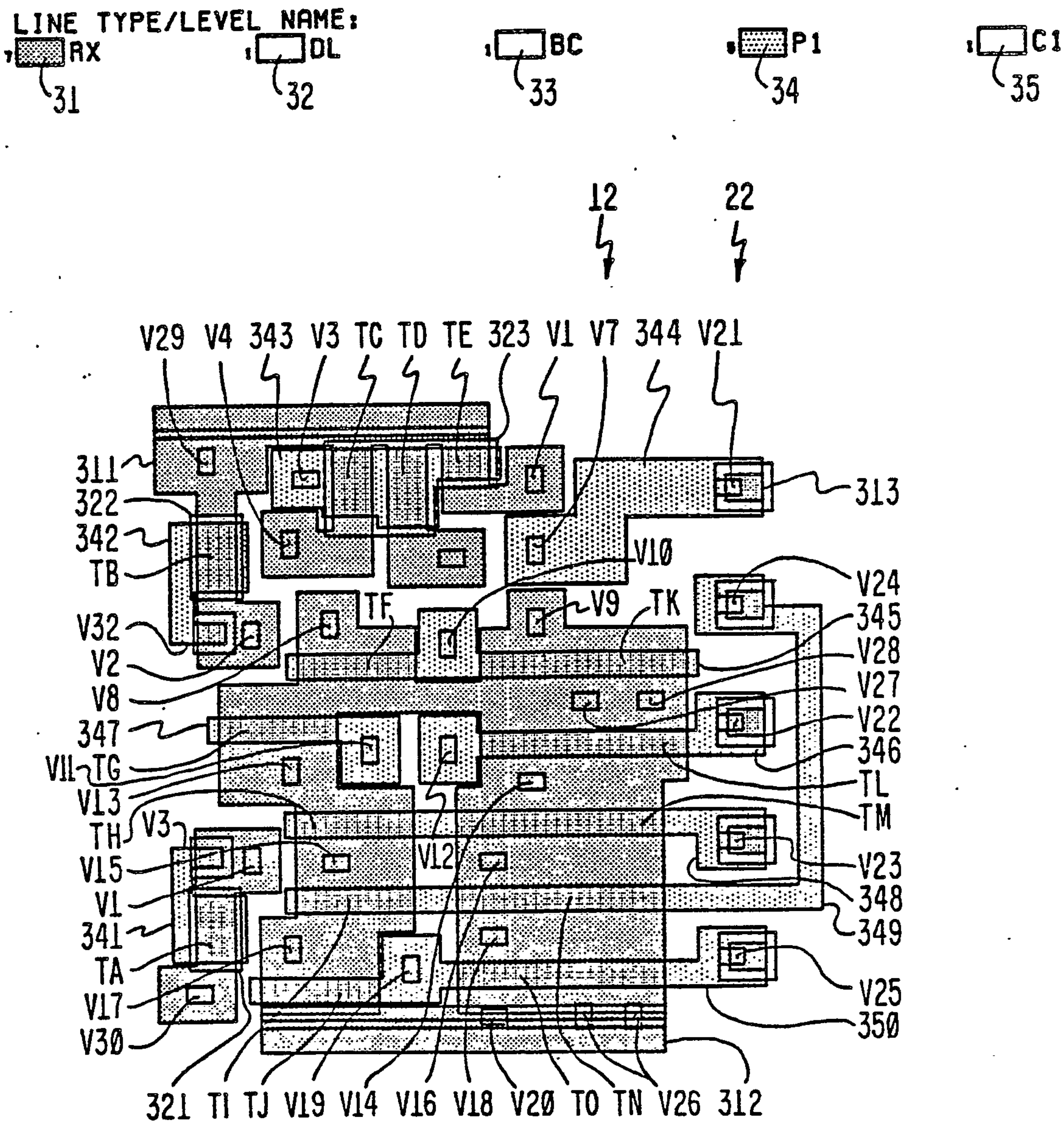
LINE TYPE/LEVEL NAME:
RX
DL
BC
P1
C1
31
32
33
34
35
12
22
V29 V4 343 V3 TC TD TE 323 V1 V7 344 V21
311
322
342
TB
V32
V2
V8
347
V11
TG
V13
TH
V3
V15
V1
341
TA
V17
V30
313
V10
V9
TF
TK
V24
345
V28
V27
V22
346
TL
TM
V12
V23
348
349
V25
350
321 TI TJ V19 V14 V16 V18 V20 TO TN V26 312

FIG. 3

FIG. 4

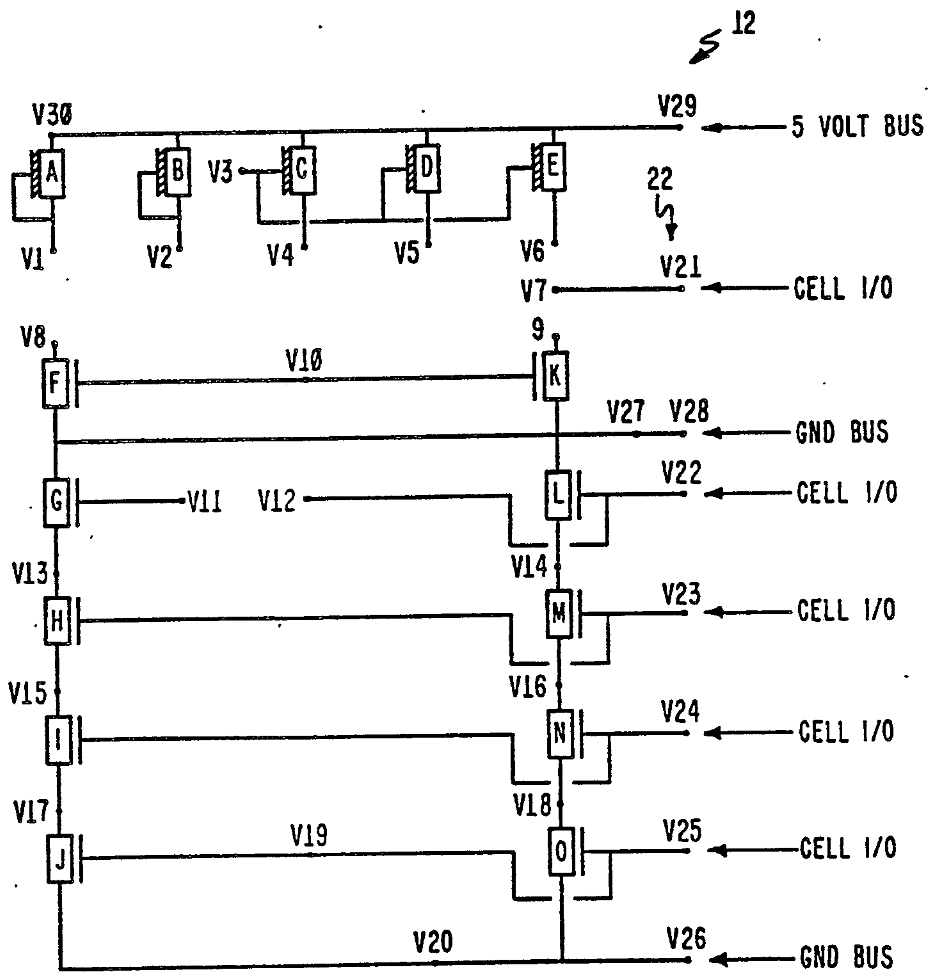
12
V30
V29
5 VOLT BUS
A
B
V3
C
D
E
22
V1
V2
V4
V5
V6
V21
V7
CELL I/O
V8
9
F
V10
K
V27
V28
GND BUS
G
V11
V12
L
V22
CELL I/O
V13
V14
H
M
V23
CELL I/O
V15
V16
I
N
V24
CELL I/O
V17
V18
J
V19
O
V25
CELL I/O
V20
V26
GND BUS

FIG. 5

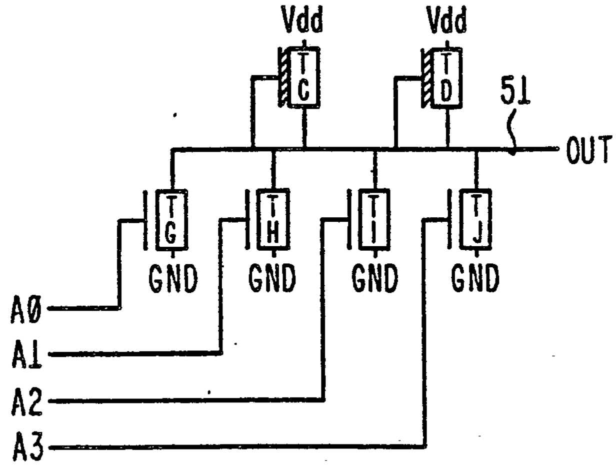
Vdd
Vdd
TC
TD
51
OUT
TG
TH
TI
TJ
GND
GND
GND
GND
A0
A1
A2
A3

FIG. 6

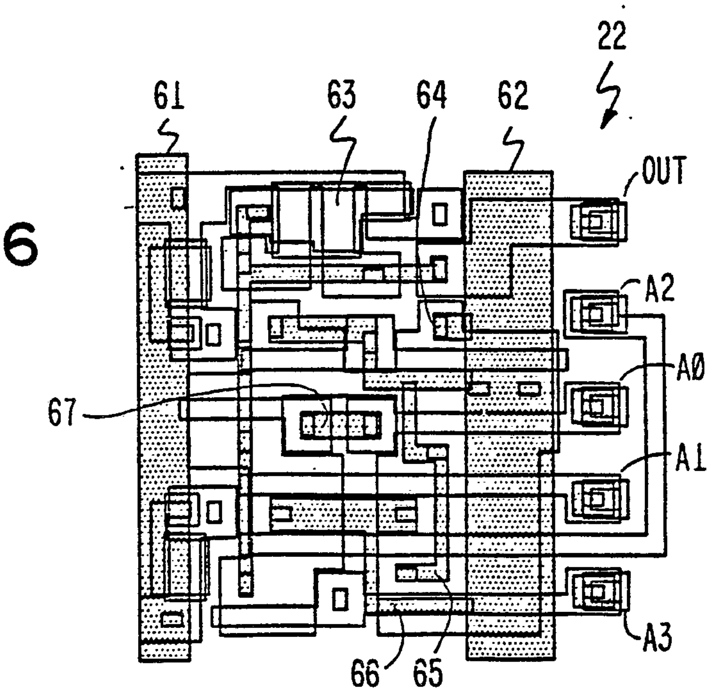
22
61
63
64
62
OUT
A2
A0
67
A1
A3
66
65

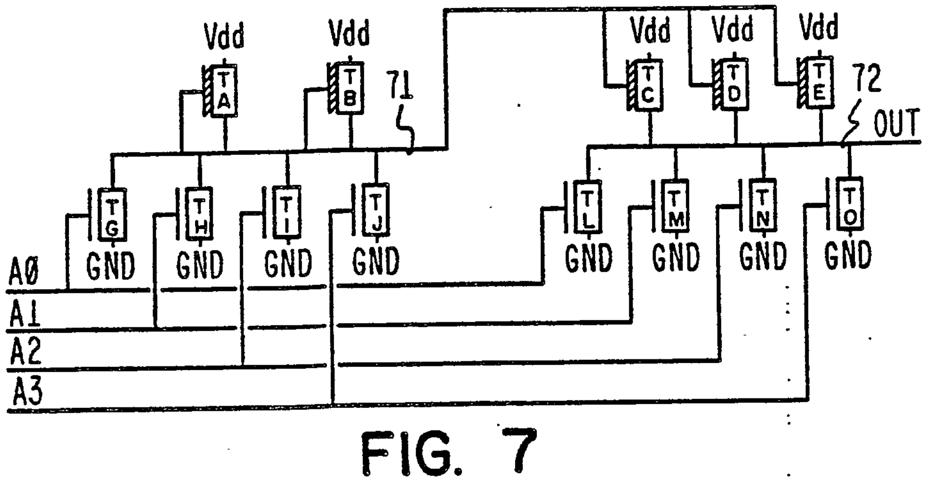
Vdd
Vdd
Vdd
Vdd
Vdd
TA
TB
TC
TD
TE
71
72
OUT
TG
TH
TI
TJ
TL
TM
TN
TO
GND
A0
A1
A2
A3

FIG. 7

FIG. 8

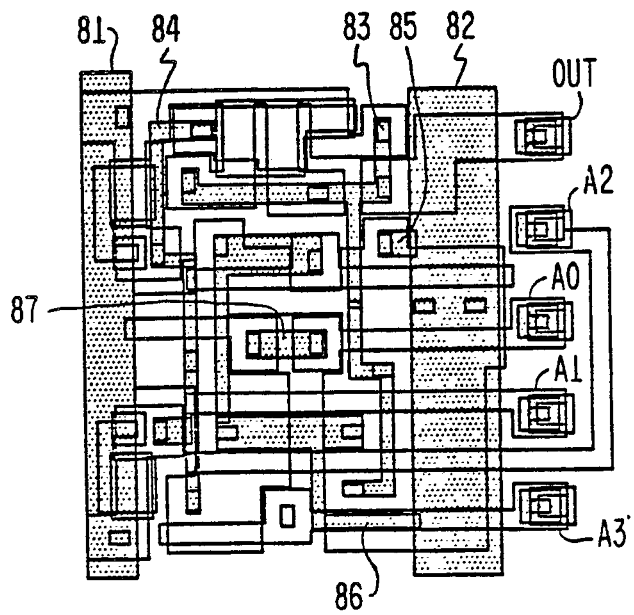
81
84
83
85
82
OUT
A2
A0
A1
A3
87
86

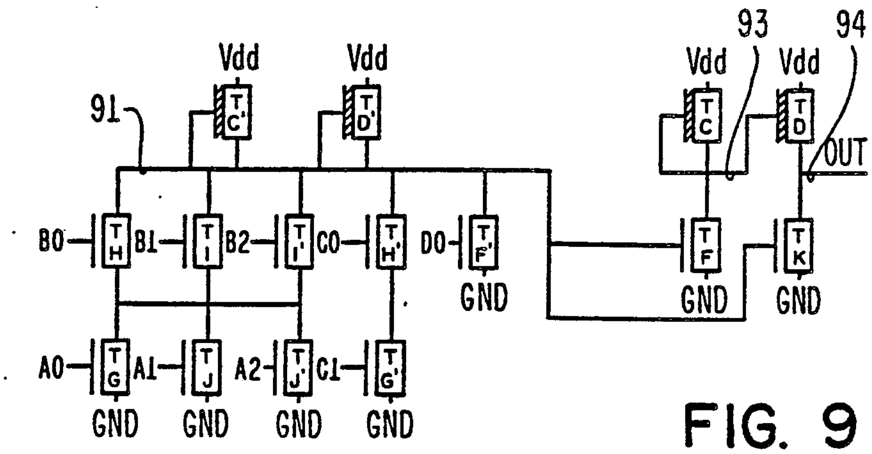
91
Vdd
Vdd
93
94
Vdd
Vdd
OUT
B0
B1
B2
C0
D0
A0
A1
A2
C1
GND
GND
GND
GND
GND
GND
GND

FIG. 9

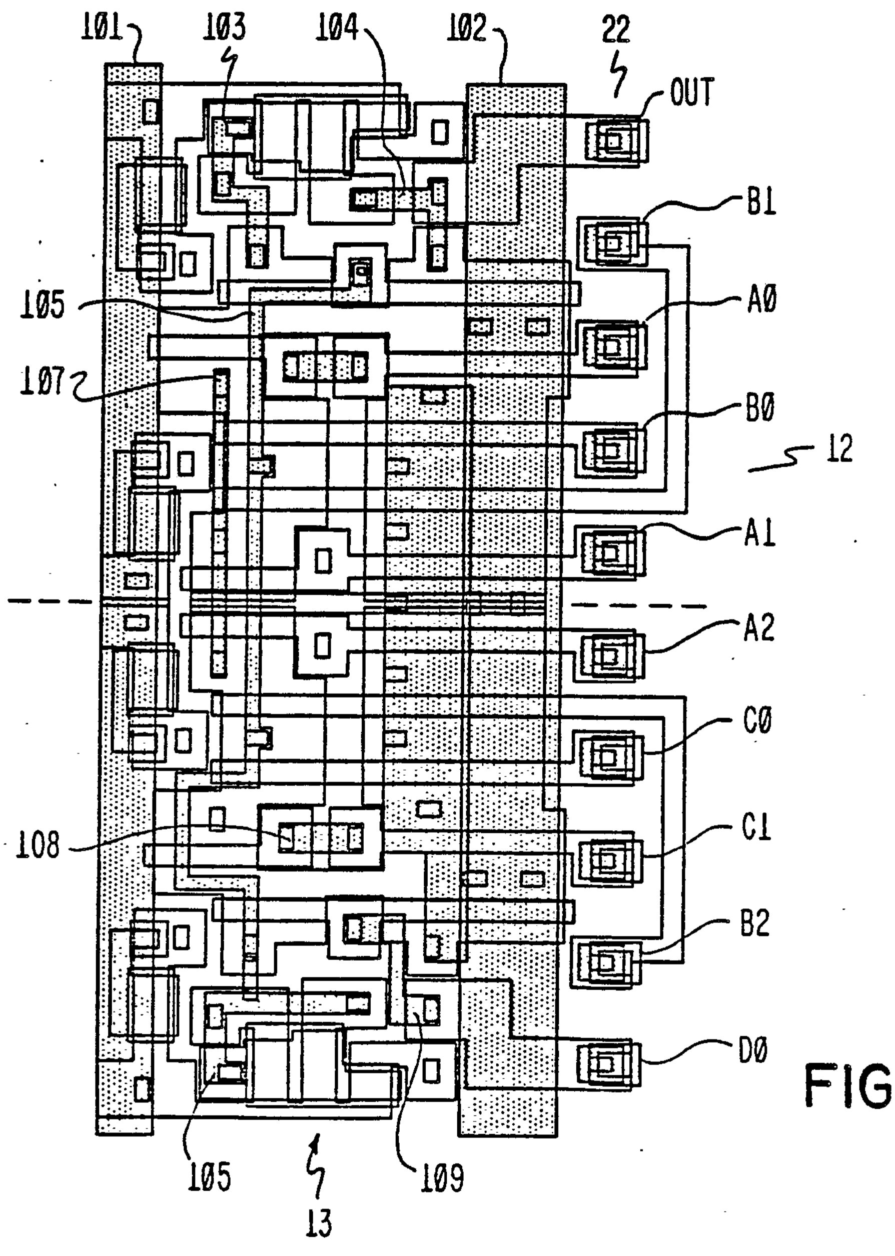
101
103
104
102
22
OUT
B1
A0
B0
12
A1
A2
C0
C1
B2
D0
105
107
108
105
109
13

FIG. 10